# FASCICULE DE BREVET EUROPEEN

(11) **EP 3 488 290 B1**
(45) Date de publication et mention de la délivrance du brevet: **18.08.2021**
(21) Numéro de dépôt: 17754399.8
(22) Date de dépôt: 20.07.2017
(51) Int. Cl.: G02F 1/225, H01S 3/10

(54) **SYSTÈME DE GÉNÉRATION D'IMPULSIONS LUMINEUSES BRÈVES OU ULTRA-BRÈVES**
SYSTEM ZUM ERZEUGEN VON KURZEN ODER ULTRAKURZEN LICHTIMPULSEN
SYSTEM FOR GENERATING BRIEF OR ULTRA-BRIEF LIGHT PULSES

(30) Priorité: 20.07.2016 FR 1656900
(43) Date de publication de la demande: 29.05.2019
(73) Titulaire: Irisiome, 33600 Pessac (FR)
(72) Inventeur: ROYON, Romain, 40100 Dax (FR); DUBRASQUET, Romain, 40630 Sabres (FR)
(74) Mandataire: Jacobacci Coralis Harle
(86) Numéro de dépôt international: PCT/FR2017/052000
(87) Numéro de publication internationale: WO 2018/015682

(56) Documents cités:
- EP-A2- 3 298 666
- WO-A2-2016/187566
- FR-A1- 3 001 053
- US-A1- 2014 300 951
- Optilab: "1550 nm Programmable Picosecond Laser, PM", , 13 juillet 2016 (2016-07-13), XP055361947, Extrait de l'Internet: URL:http://www.optilab.com/images/datashee ts/PPL-1064-PM_07132016_v1.pdf [extrait le 2017-04-05]
- OZEKI Y ET AL: "Repetition rate and wavelength tunable picosecond optical pulse source employing square-wave-driven modulator, comb-like profiled fibre compressor and pulse timing stabilizer", 31ST EUROPEAN CONFERENCE ON OPTICAL COMMUNICATION - 25-29 SEPT. 2005 - GLASGOW, UK, LONDON : INSTITUTION OF ELECTRICAL ENGINEERS, GB, 25 septembre 2005 (2005-09-25), pages 41-42vol.1, XP032173339, ISBN: 978-0-86341-543-2
- TAIRA K ET AL: "Picosecond pulse generation with high extinction ratio employing electroabsorption modulator, fibre compressor, and self-phase-modulation-based pulse reshaper", ELECTRONICS LETTERS, IEE STEVENAGE, GB, vol. 40, no. 1, 8 janvier 2004 (2004-01-08), pages 15-16, XP006024614, ISSN: 0013-5194, DOI: 10.1049/EL:20040057
- IREDALE T B ET AL: "40 GHz sub-picosecond pulse generation from a Mach-Zehnder modulator and its application to 320 Gb/s OTDM", OPTICAL FIBER COMMUNICATION - INCUDES POST DEADLINE PAPERS, 2009. OFC 2009. CONFERENCE ON, IEEE, PISCATAWAY, NJ, USA, 22 mars 2009 (2009-03-22), pages 1-3, XP031468087, ISBN: 978-1-4244-2606-5

## Description

### DOMAINE TECHNIQUE AUQUEL SE RAPPORTE L'INVENTION

La présente invention concerne de manière générale le domaine des systèmes de génération d'impulsions lumineuses et des lasers.

Elle concerne plus particulièrement un système et procédé de génération d'impulsions lumineuses brèves ou ultrabrèves, ces impulsions lumineuses étant accordables en cadence ou fréquence de répétition.

Elle concerne en particulier un système et procédé de génération d'impulsions lumineuses ultrabrèves étant de plus accordables en durée et/ou en longueur d'onde.

### ARRIERE-PLAN TECHNOLOGIQUE

L'utilisation d'impulsions lumineuses brèves à ultra-brèves trouve de nombreuses applications dans les domaines scientifique, industriel ou médical. Dans le présent document, on entend par impulsion lumineuse brève, une impulsion lumineuse ayant une durée comprise entre plusieurs picosecondes et quelques picosecondes. On entend par impulsion lumineuse ultrabrève, une impulsion lumineuse ayant une durée comprise entre la femtoseconde (fs) et la dizaine picoseconde (ps). Dans le présent document, on utilise de manière équivalente les termes fréquence de répétition et cadence.

Les lasers à fibre optique sont actuellement couramment utilisés pour la génération d'impulsions lumineuses brèves à ultra-brèves. En particulier, les fibres optiques dopées avec des éléments terres rares, en particulier l'ytterbium, présentent généralement une large bande de gain dans le domaine de l'infrarouge autour de 1 µm (généralement de 976 à 1200 nm). La combinaison d'une fibre dopée à large bande de gain avec un dispositif de verrouillage de modes actif ou passif permet la génération d'impulsions lumineuses brèves (ps) ou ultra-brèves (fs). De plus, ces fibres dopées ont en général un fort gain. Ce gain élevé rend possible l'introduction d'éléments optiques, tels que des filtres, sans altérer le fonctionnement d'un tel laser à fibre.

Les systèmes laser à fibre optique présentent des avantages de compacité et d'intégration. En outre, le développement des fibres optiques à double gaine et à large cœur a permis de générer des impulsions lumineuses de haute puissance moyenne et/ou de haute énergie. Les systèmes laser à fibre optique sont actuellement des concurrents sérieux aux lasers à milieu solide pompés par diode.

En effet, les oscillateurs optiques basés sur des cristaux massifs ont permis de démontrer des puissances moyennes importantes, en particulier avec la technologie de laser à disque mince (thin-disk) pour atteindre des énergies par impulsion de plusieurs joules en régime femtoseconde.

Toutefois, les architectures de ces systèmes laser à milieu solide sont très complexes. Ces systèmes laser à cristaux présentent des inconvénients de sensibilité aux variations de l'environnement extérieur. Ces inconvénients sont un frein à l'intégration des lasers à milieu solide dans des appareils industriels.

Bien que les lasers à fibre présentent certains avantages par rapport aux lasers à solide, ils présentent encore de nombreux inconvénients. Dans un laser à fibre, les impulsions lumineuses sont confinées spatialement dans le volume réduit d'une fibre optique. Du fait de ce confinement, les impulsions lumineuses peuvent être à l'origine d'effets optiques non-linéaires susceptibles de limiter l'énergie (ou la puissance crête) d'un laser fibré à verrouillage de mode. D'autre part, la dispersion chromatique dans une fibre optique peut aussi occasionner des dysfonctionnements notamment pour des lasers accordables en longueur d'onde.

Pourtant, les lasers à fibre couvrent un champ très large tant du point de vue des longueurs d'onde que des durées ou des énergies d'impulsions lumineuses. En pratique, ce vaste choix n'est cependant accessible que par la mise en œuvre d'un nombre considérable d'architectures de laser à fibre différents.

De manière générale, le processus de verrouillage de modes dans une cavité laser résonante est le mécanisme choisi pour la génération d'impulsions lumineuses ultra-courtes (fs ou ps). Ce procédé verrouillage de modes reste complexe, car un nombre important de modes longitudinaux oscillant dans la cavité doit être mis en phase.

Pour ce faire, il existe différentes techniques de verrouillage de mode actif ou passif.

Le verrouillage de modes actif consiste à disposer un modulateur acousto-optique ou électro-optique dans une cavité laser et à moduler de manière active les pertes de la cavité en fonction du temps. Le verrouillage de modes actif nécessite l'utilisation d'une alimentation électrique externe pour commander le modulateur optique. De plus, la durée des impulsions générées par verrouillage de mode actif est de l'ordre de plusieurs dizaines ou centaines de picosecondes.

Le verrouillage de modes passif repose sur l'exploitation d'effets optiques non-linéaires afin de générer des impulsions sans avoir recours à un modulateur optique externe. Plusieurs méthodes basées sur la variation des pertes en fonction de l'intensité (effet d'absorbant saturable) sont utilisées comme par exemple : les miroirs semi-conducteurs non linéaires (SESAM), les miroirs à boucle optique non-linéaire (NOLM), les miroirs à boucle amplificatrice non-linéaire (NALM) ou la rotation non-linéaire de polarisation (RNLP). Ces techniques optiques non-linéaires fonctionnent dans des conditions précises.

Toutefois ces méthodes optiques non linéaires sont difficilement utilisables dans des systèmes lasers accordables en longueur d'onde, en durée d'impulsions et/ou en fréquence de répétition.

En effet, la technologie des SESAM's permet de concevoir et réaliser une variété d'éléments au fonctionnement adapté individuellement à chacune des longueurs d'onde du spectre d'émission de l'ion Ytterbium mais avec une bande spectrale limitée intrinsèquement à quelques dizaines de nanomètres seulement. Il n'est donc pas possible d'utiliser un seul SESAM sur une gamme d'accordabilité en longueur d'onde étendue.

Il en est de même pour la technique de NALM, dont le fonctionnement est basé sur le gain et la dispersion totale de la cavité. De plus, les degrés de liberté pour obtenir le verrouillage de mode sont extrêmement réduits et nécessitent un haut niveau de maîtrise de cette technologie.

Enfin, la RNLP fait appel à des composants optiques en espace libre tels que les lames de phase. Ces composants optiques n'étant pas disponibles en technologie fibrée, leur utilisation implique de propager le faisceau en espace libre hors de la fibre. Il n'est donc pas possible de réaliser des sources lasers entièrement fibrées par cette technologie. Par ailleurs, une variation de la biréfringence de la fibre par effet thermique ou mécanique dégrade le verrouillage des modes. Il faut alors fréquemment réajuster l'orientation des lames de phase pour à nouveau obtenir un train d'impulsions stables.

Le document Ozeki et al. (« Repetition rate and wavelength tunable picosecond optical pulse source employing square-wave-driven modulator, comb-like profiled fibre compressor an pulse timing stabilizer », 31st European Conférence on Optical Communication, 25-29 sept. 2005, pages 41-42, vol. 1) décrit un générateur d'impulsions optiques courtes comprenant une source laser à cavité externe (ECL laser) émettant un rayonnement continu à 1064 nm et un modulateur optique de type interféromètre de Mach-Zehnder (MZI) disposé en sortie de la source laser, modulé en intensité par un signal RF.

En outre, ces systèmes restent intrinsèquement figés au niveau des cadences de répétition et de la durée d'impulsions délivrées. En effet, la durée d'impulsion et la fréquence de répétition sont imposées par les caractéristiques de la cavité laser, en particulier la longueur de la cavité.

Il existe donc un besoin pour un système et procédé de génération d'impulsions lumineuses brèves ou ultrabrèves, ces impulsions lumineuses étant accordables en fréquence de répétition sur une large gamme de fréquence.

Il existe aussi un besoin pour un système et procédé de génération d'impulsions lumineuses ultrabrèves, ces impulsions lumineuses étant accordables en durée sur une large gamme temporelle et/ou en longueur d'onde sur une large gamme spectrale.

### OBJET DE L'INVENTION

Afin de remédier à l'inconvénient précité de l'état de la technique, la présente invention propose un système de génération d'impulsions lumineuses brèves ou ultra-brèves.

Plus particulièrement, on propose selon l'invention un système selon la revendication 1.

De préférence, la bande passante du générateur électrique s'étend du continu jusque 5 GHz ou même 100 GHz.

Ce système représente une rupture technologique dans le domaine des sources lumineuses d'impulsions brèves ou ultrabrèves car il n'utilise pas de cavité laser résonante ni de verrouillage de modes. Ce système de génération d'impulsions lumineuses présente de nombreux avantages de compacité, de facilité d'utilisation et de gamme de fonctionnement. Il est aisément accordable en durée d'impulsion lumineuse, en cadence de répétition et/ou en longueur d'onde.

D'autres caractéristiques non limitatives et avantageuses du système de génération d'impulsions lumineuses brèves ou ultra-brèves conforme à l'invention, prises individuellement ou selon toutes les combinaisons techniquement possibles, sont les suivantes :
- le générateur électrique est configuré pour émettre le signal électrique analogique de modulation comprenant ladite au moins une impulsion électrique de durée comprise entre 10 ps et quelques nanosecondes et la source lumineuse comprend une diode laser ayant des électrodes, lesdits moyens de modulation étant configurées pour appliquer ledit signal électrique analogique de modulation sur les électrodes de la diode laser ;
- le générateur électrique est configuré pour opérer à une fréquence accordable dans une bande passante s'étendant jusqu'au moins dix gigahertz et pour émettre le signal électrique analogique de modulation comprenant ladite au moins une impulsion électrique de durée comprise entre 10 ps et 50 ps et dans lequel la diode laser est commutée en gain, de manière à ce que la diode laser génère le rayonnement lumineux modulé comprenant au moins une impulsion lumineuse de durée comprise entre 10 ps et 50 ps à une cadence s'étendant jusqu'au moins dix gigahertz.

Selon un mode de réalisation particulier et avantageux, la source lumineuse est adaptée pour émettre un rayonnement lumineux continu temporellement, le générateur électrique est configuré pour opérer à une fréquence accordable dans une bande passante comprise entre un gigahertz et une centaine de gigahertz et pour émettre le signal électrique analogique de modulation comprenant ladite au moins une impulsion électrique de durée comprise entre dix picosecondes et une centaine de picosecondes; et le système comprend en outre un modulateur électro-optique ayant des électrodes et une bande passante électrique adaptées pour recevoir le signal électrique analogique de modulation, le modulateur électro-optique étant configuré pour moduler optiquement en amplitude le rayonnement lumineux continu en fonction du signal électrique analogique de modulation et pour générer un rayonnement lumineux modulé comprenant au moins une impulsion lumineuse de durée comprise entre 10 ps et 100 ps.

Selon d'autres aspects particuliers et avantageux :
- le générateur d'impulsions électriques est configuré pour émettre un signal électrique analogique de modulation comprenant un train d'impulsions électriques de durée comprise entre 10 ps et 10 ns à une cadence accordable dans une gamme de fréquence comprise entre 10 kHz et 20 Ghz et dans lequel le modulateur électro-optique est configuré pour moduler le rayonnement lumineux continu en fonction du signal électrique analogique de modulation et pour générer un rayonnement lumineux modulé comprenant un train d'impulsions lumineuses de durée comprise entre 10 ps et 10 ns, lesdites impulsions lumineuses ayant ladite cadence accordable ;
- le système comprend en outre un dispositif optique de compression d'impulsion configuré pour recevoir ladite au moins une impulsion lumineuse de durée comprise entre dix picosecondes et une centaine de picosecondes et pour générer une impulsion lumineuse comprimée de durée inférieure ou égale à une picoseconde ;
- le système comprend en outre au moins un dispositif optique disposé entre la source lumineuse et le compresseur, le dispositif optique étant choisi parmi un dispositif optique spectralement dispersif, un dispositif optique polarisant, un dispositif optique non linéaire d'automodulation de phase et/ou un dispositif optique non linéaire à effet Kerr ;
- la source lumineuse est configurée pour émettre un rayonnement lumineux continu monochromatique ou polychromatique ;
- le système comprend un dispositif d'accord d'une longueur d'onde du rayonnement lumineux continu ;
- la source lumineuse comprend une diode laser ou une source laser à fibre optique dopée terre rare, choisie parmi une source laser à fibre optique dopée erbium, ytterbium, thulium ou néodyme ;
- le système comprend un dispositif d'amplification optique configuré pour recevoir le rayonnement lumineux modulé et pour générer un rayonnement lumineux impulsionnel amplifié ;
- le système comprend un coupleur optique disposé en sortie des moyens de modulation électriques ou électro-optiques et configuré pour prélever une portion du rayonnement lumineux modulé, un système de détection configuré pour mesurer une intensité de la portion du rayonnement lumineux modulé dans une bande passante s'étendant jusqu'à au moins un gigahertz et de préférence jusque 5 GHz et même 100 GHz, et une boucle de rétroaction disposée pour appliquer un signal de biais sur le signal de modulation en fonction de l'intensité mesurée ;
- le système comprend un système optique agrandisseur de faisceau disposé pour recevoir le rayonnement lumineux modulé et pour diriger un faisceau lumineux modulé agrandi sur une zone à analyser et un système de détection d'image configuré pour former une image de ladite zone.

L'invention propose également un procédé de génération d'impulsions lumineuses brèves ou ultra-brèves comprenant les étapes suivantes :
- émission d'un rayonnement lumineux, par exemple continu temporellement,
- génération d'un signal électrique analogique de modulation ayant une bande passante hyperfréquence comprise entre 10 kHz et 20 Ghz, le signal électrique analogique de modulation comprenant au moins une impulsion électrique de durée comprise entre 10 ps et 100 ps ;
- application du signal électrique analogique de modulation aux électrodes d'un modulateur électro-optique ou d'une diode laser, le modulateur électro-optique ou la diode laser étant configuré pour moduler optiquement en amplitude le rayonnement lumineux continu en fonction du signal électrique analogique de modulation et pour générer un rayonnement lumineux modulé comprenant au moins une impulsion lumineuse de durée comprise entre 10 ps et 100 ps.

Dans une variante avantageuse du procédé, la diode laser est commutée en gain, de manière à ce que la diode laser génère le rayonnement lumineux modulé comprenant au moins une impulsion lumineuse de durée comprise entre 10 ps et 50 ps à une cadence s'étendant jusqu'au moins dix gigahertz.

### DESCRIPTION DETAILLEE D'UN EXEMPLE DE REALISATION

La description qui va suivre en regard des dessins annexés, donnés à titre d'exemples non limitatifs, fera bien comprendre en quoi consiste l'invention et comment elle peut être réalisée.

Sur les dessins annexés :
- la figure 1 représente schématiquement un système de génération d'impulsions lumineuses brèves ou ultra-brèves selon un mode de réalisation ;
- la figure 2 représente un exemple de signal électrique analogique de modulation comprenant une impulsion électrique, ce signal électrique analogique de modulation étant généré par le générateur électrique ;

- la figure 3 représente un exemple de rayonnement lumineux modulé généré en sortie d'un modulateur électro-optique auquel est appliqué le signal électrique analogique de modulation de la figure 2 ;
- la figure 4 représente un exemple d'impulsion lumineuse ultra-brève obtenue après compression du rayonnement lumineux modulé de la figure 3 ;
- la figure 5 représente schématiquement une variante du système de génération d'impulsions lumineuses avec boucle de contre-réaction ;
- la figure 6 représente schématiquement différentes variantes du système de génération d'impulsions lumineuses utilisant un ou plusieurs dispositifs d'amplification, de dispersion et/ou de compression d'impulsion ;
- la figure 7 représente schématiquement un dispositif de rotation non-linéaire de la polarisation ;
- la figure 8 représente un exemple de génération d'impulsion lumineuse accordable en longueur d'onde sur une large gamme spectrale.

### Dispositif

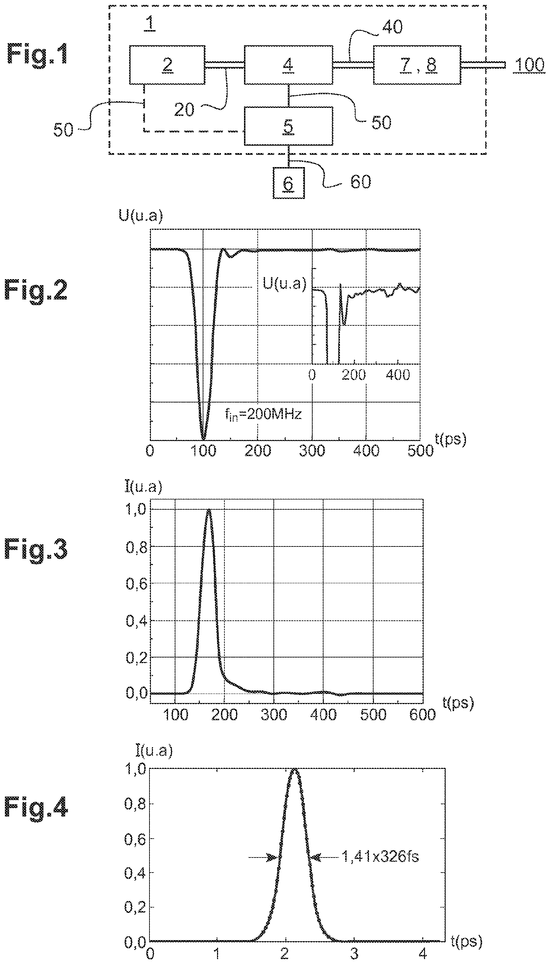

Sur la figure 1, on a représenté un système 1 de génération d'impulsions lumineuses 100 qui comprend une source lumineuse 2, un générateur électrique 5, une unité de commande 6 et un modulateur électro-optique 4. Dans une variante, le système 1 de génération d'impulsions lumineuses comporte en outre un module de dispersion 7 et/ou de compression 8 d'impulsions lumineuses. Sur la figure 1, les signaux électriques sont représentés par un trait simple et les faisceaux lumineux par un trait double.

La source lumineuse 2 émet un rayonnement lumineux 20 qui est continu temporellement. La source lumineuse 2 comprend par exemple une source laser ayant de préférence une sortie fibrée. De façon particulièrement avantageuse, la source lumineuse 2 émet un rayonnement lumineux 20 monochromatique accordable en longueur d'onde. De préférence, la source lumineuse 2 génère un rayonnement lumineux monomode transverse TM₀₀.

Dans un exemple de réalisation, la source lumineuse 2 comprend une diode laser qui émet un rayonnement lumineux 20 à une longueur d'onde déterminée pouvant être ajustée sur quelques nanomètres en fonction de la température de la diode laser. Dans un autre exemple, la source lumineuse 2 comporte par exemple un oscillateur optique et un filtre accordable en longueur d'onde. La source lumineuse 2 comporte par exemple une source laser à fibre dopée terre rare. Ainsi par exemple, une source laser à fibre dopée ytterbium peut être continûment accordable en longueur d'onde sur une gamme spectrale d'émission de l'ytterbium s'étendant de 974 nm jusqu'à 1200 nm. Cette accordabilité peut être obtenue en insérant un élément discriminant (tel que par exemple un filtre, élément polarisant ou autre) dans une cavité laser pour introduire des pertes aux longueurs d'onde non désirées. Dans un autre exemple, une source laser à fibre dopée erbium peut être continûment accordable sur une gamme spectrale d'émission de l'erbium autour de 1,5 µm. Selon encore un autre exemple, une source laser à fibre dopée thulium peut être continument accordable sur une gamme spectrale d'émission du thulium autour de 2 micromètres (µm). De manière similaire, une source laser à fibre dopée néodyme peut être continument accordable en longueur d'onde sur une gamme spectrale autour de la longueur d'onde d'émission de 900 nm. Les sources laser à fibre dopée terre rare émettent un rayonnement lumineux 20 continu temporellement, ayant une puissance de plusieurs centaines de milliwatts et qui est accordable en longueur d'onde sur une large gamme spectrale de plusieurs dizaines à centaines de nm dans le domaine visible et/ou proche infrarouge.

De manière alternative, la source lumineuse 2 émet un rayonnement lumineux 20 polychromatique comprenant plusieurs longueurs d'onde discrètes dans un domaine spectral s'étendant sur quelques centaines de nanomètres, chaque longueur d'onde discrète ayant une largeur spectrale de l'ordre de 10 kHz jusqu'à 300 GHz.

Le rayonnement lumineux 20 continu temporellement est injecté à l'entrée d'un modulateur électro-optique 4. Le modulateur électro-optique 4 est de préférence un modulateur d'amplitude de type Mach-Zehnder. On choisit un modulateur électro-optique 4 ayant une bande passante électronique s'étendant de 10 GHz à 20 GHz ou de 5 GHz jusqu'à 100 GHz. Par exemple, le modulateur électro-optique 4 Mach-Zehnder est un modulateur sur un circuit intégré optique, comprenant un guide d'onde optique et des électrodes. De façon avantageuse, le modulateur électro-optique 4 comporte au moins une entrée à fibre optique et une sortie à fibre optique. Les électrodes du modulateur électro-optique 4 Mach-Zehnder sont reliées à un générateur électrique 5.

Le générateur électrique 5 reçoit un signal de commande 60 analogique extérieur généré par l'unité de commande et applique un signal électrique analogique de modulation 50 sur les électrodes du modulateur électro-optique 4. Dans une variante détaillée plus loin, le signal électrique analogique de modulation 50 est appliqué directement sur les électrodes d'une diode laser source 2.

Plus précisément, le générateur électrique 5 comporte une carte électronique rapide configurée pour générer un signal électrique analogique de modulation 50 comprenant au moins une impulsion électrique de durée comprise entre 10 ps et 10 ns. De façon avantageuse, cette impulsion électrique a une amplitude comprise entre 2 et 4V, adaptée pour contrôler le modulateur électro-optique 4. A titre d'exemple non limitatif, la carte électronique comporte des composants électroniques hyperfréquences numériques opérant dans le domaine de 28 Gbps à 32 Gbps ou de 100 Gbps. De tels composants électroniques hyperfréquences sont utilisés en électronique logique pour des signaux de télécommunications rapides de faible amplitude, mais ne sont pas adaptés à fournir des signaux analogiques. Selon l'invention, on utilise deux portes logiques inversées l'une par rapport à l'autre et reliées par une ligne à retard électronique pour générer une impulsion électrique analogique de durée comprise entre 10 ps et 10 ns. La ligne à retard électronique détermine la durée de l'impulsion électrique analogique. Dans un mode de réalisation avantageux, la ligne à retard électronique est à retard variable de manière à générer une impulsion électrique analogique de durée variable, comprise entre 10 ps et 10 ns. Toutefois, les composants électroniques logiques hyperfréquence ne permettent pas de commander directement un modulateur électro-optique de type Mach-Zehnder. En effet, un tel modulateur nécessite des tensions de commutation de plusieurs volts. Un système d'amplificateur opérationnel à large bande passante (environ 20 GHz) permet de générer un signal électrique analogique de modulation ayant une amplitude comprise par exemple entre 2 V et 4 V sur une bande passante s'étendant de quelques kHz jusqu'à au moins 5 GHz, et de préférence jusqu'à 10 GHz, 20 GHz et même 100 GHz.

Avantageusement, le signal électrique analogique de modulation 50 est un signal périodique ayant une fréquence de répétition accordable par exemple de 50 kHz à au moins 5 GHz. Le générateur électrique 5 génère ainsi un train d'impulsions électriques avec une cadence accordable de 50 kHz à au moins 5 GHz. Le train d'impulsions électriques peut comprendre des impulsions électriques de durée fixe ou de durée variable, comprise entre 10 ps et 10 ns.

Par exemple, un ordinateur ou une horloge 6 envoie un signal de commande 60 analogique à une carte électronique hyperfréquence telle que décrite ci-dessus de manière à générer un signal électrique analogique de modulation 50 modulé temporellement dans le domaine fréquentiel s'étendant de quelques kHz jusqu'à plusieurs GHz ou même plusieurs dizaines de GHz.

Ce générateur électrique 5 permet de disposer d'un signal électrique analogique de modulation 50 comprenant une impulsion électrique analogique générée à la demande ou un train d'impulsions électriques analogiques (2-4V) avec une cadence accordable de 50 kHz jusqu'au moins 5 GHz, 10 GHz, 20 GHz ou même 50 GHz et de durée variable (10 ps-10 ns). De plus, un tel générateur électrique 5 a des avantages de faible consommation et de coût maitrisé.

La figure 2 illustre un exemple de signal électrique analogique de modulation 50 en sortie d'un amplificateur disposé en sortie d'un générateur électrique 5 tel que décrit ci-dessus. Le générateur électrique 5 reçoit un signal de commande 60 à une fréquence fᵢₙ de 200 MHz et génère un signal électrique analogique dont l'amplitude varie ici entre -0,5 V et 0 V. Toutefois, dans les applications en photonique, il est important de contrôler précisément les caractéristiques du signal électrique analogique de modulation 50. En particulier, le contraste du signal électrique analogique de modulation 50 doit être excellent, c'est-à-dire le rapport entre le niveau crête de l'impulsion électrique et le niveau des perturbations. En insert de la Figure 2, on a représenté le signal électrique analogique de modulation 50 en échelle logarithmique. On observe que l'amplitude des rebonds reste inférieure à 4% à ce qui convient très bien pour un modulateur électro-optique de type Mach-Zehnder.

Ce signal électrique analogique de modulation 50 peut délivrer une impulsion électrique analogique unique et/ou un train périodique d'impulsions électriques analogiques à une fréquence de répétition allant de 10 kHz jusqu'à au moins 5GHz, voire 20 GHz ou même 50 GHz.

La génération d'impulsions lumineuses se fait au moyen d'un générateur électrique 5, comme celui décrit plus haut, qui délivre des impulsions électriques de durée comprise entre 10 ps et 10 ns et d'un modulateur électro-optique 4 à large bande passante.

Le signal électrique analogique de modulation 50 est appliqué entre les électrodes du modulateur électro-optique 4. Le modulateur électro-optique 4 reçoit le rayonnement lumineux 20 continu temporellement et module l'amplitude de ce rayonnement lumineux 20 en fonction du signal électrique analogique de modulation 50 pour générer un rayonnement lumineux modulé 40. Le modulateur électro-optique 4 a une bande passante électronique s'étendant jusqu'au moins 5 GHz, par exemple de jusqu'à 10 GHz, 20 GHz ou 100 GHz. Le signal électrique analogique de modulation 50 comprend au moins une impulsion électrique analogique de durée comprise entre 10 ps et 10 ns. Ainsi, le signal électrique analogique de modulation 50 induit un rayonnement lumineux modulé 40 comprenant au moins une impulsion lumineuse de durée comprise entre 10 ps et 10 ns. Autrement dit, le modulateur électro-optique 4 convertit optiquement le signal électrique analogique de modulation 50 en un rayonnement lumineux modulé 40 comprenant au moins une impulsion lumineuse de durée comprise entre 10 ps et 10 ns.

La figure 3 illustre un exemple de mesure d'intensité du rayonnement lumineux modulé 40 en sortie d'un modulateur électro-optique 4 auquel est appliqué le signal électrique analogique de modulation de la figure 2. On observe une impulsion lumineuse qui présente un fort contraste et a une durée d'environ 25 ps, qui est ici égale à la durée de l'impulsion électrique appliquée. Le modulateur électro-optique 4 génère ainsi directement une impulsion lumineuse de durée inférieure à 100 ps.

Le modulateur électro-optique 4 peut ainsi délivrer une impulsion lumineuse unique de durée comprise entre 10 ps et 10 ns ou un train d'impulsions lumineuses à une fréquence de répétition pouvant aller de 10 kHz jusqu'à 5 GHz, 20 GHz ou même 50 GHz, en fonction du signal électrique analogique de modulation 50.

Le système constitué d'une source lumineuse 2, d'un générateur électrique 5 et d'un modulateur électro-optique 4 tels que décrits ci-dessus permet ainsi de découper temporellement le rayonnement lumineux continu de la source lumineuse 2 pour produire des impulsons lumineuses picosecondes ayant un rapport signal à bruit très élevé et une forme temporelle bien contrôlée. Ces impulsons lumineuses peuvent avoir une cadence ajustable tout en ayant une amplitude stable.

Premièrement, ce système permet aisément d'ajuster électroniquement la durée des impulsions lumineuses dans une large gamme de durée. Ensuite, un tel système permet aisément d'ajuster électroniquement la fréquence de répétition des impulsions lumineuses dans une large gamme de fréquence, sans générer d'instabilités. Ce système permet ainsi d'atteindre un domaine de fréquence de répétition élevé. De plus, ce système permet aussi d'atteindre un domaine de fréquence de répétition à basse fréquence de répétition, qui est difficile à atteindre avec un dispositif conventionnel de sélection d'impulsion lumineuse (ou pulse-picker).

De façon particulièrement avantageuse, le système de génération d'impulsions lumineuses comporte en outre un compresseur 8, par exemple un compresseur spectral conventionnel à base de réseaux de diffraction et/ou de prisme. Le compresseur 8 permet de comprimer temporellement une impulsion lumineuse de durée comprise entre 10 ps et 100 ps préalablement chirpée ou mise en forme afin de générer un spectre ayant une relation de phase entre ses différentes composantes spectrales en une impulsion lumineuse de durée femtoseconde, c'est-à-dire inférieure à 1 ps. On fabrique ainsi une source femtoseconde, qui est compacte, et aisément accordable en durée, cadence et/ou longueur d'onde.

La figure 4 illustre une mesure d'impulsion lumineuse compressée temporellement en sortie d'un système tel que représenté schématiquement sur la figure 1 et comprenant un compresseur 8. Le compresseur reçoit une impulsion lumineuse de durée de l'ordre de 50 ps, comme illustré sur la figure 3, et génère une impulsion lumineuse ultra-brève 100. Sur la figure 4, on a représenté une courbe d'ajustement gaussien du profil temporel de l'impulsion lumineuse 100. On détermine ainsi la durée de l'impulsion lumineuse qui ici est égale à environ 460 fs en durée auto-corrélateur soit environ 326 fs en durée réelle.

Selon une variante, le générateur électrique 5 applique des impulsions électriques directement sur les électrodes de la source lumineuse 2, qui est par exemple une diode laser signal ayant des électrodes pour l'alimenter en courant électrique. Dans cette variante, le modulateur électro-optique 4 est omis. De cette manière, la diode génère en sortie directement un rayonnement lumineux modulé 40 comprenant des impulsions lumineuses ayant une durée comprise entre 50 ps jusqu'à plusieurs ns et avec une cadence comprise dans une gamme de 0 jusqu'à 1GHz. Dans le but de réduire la durée d'impulsion, la diode signal peut être commutée en gain (ou gain switched) par application directe d'impulsions électriques de commande sur ses électrodes afin d'obtenir des impulsions lumineuses de durée comprise entre 5 et 50 ps à une cadence comprise entre 0 à 10 GHz. De façon alternative, on module l'amplitude du courant électrique appliqué sur les électrodes de la diode laser pour générer directement des impulsions lumineuses de durée comprise entre 5 et 50 ps à une cadence comprise entre 0 à 10 GHz.

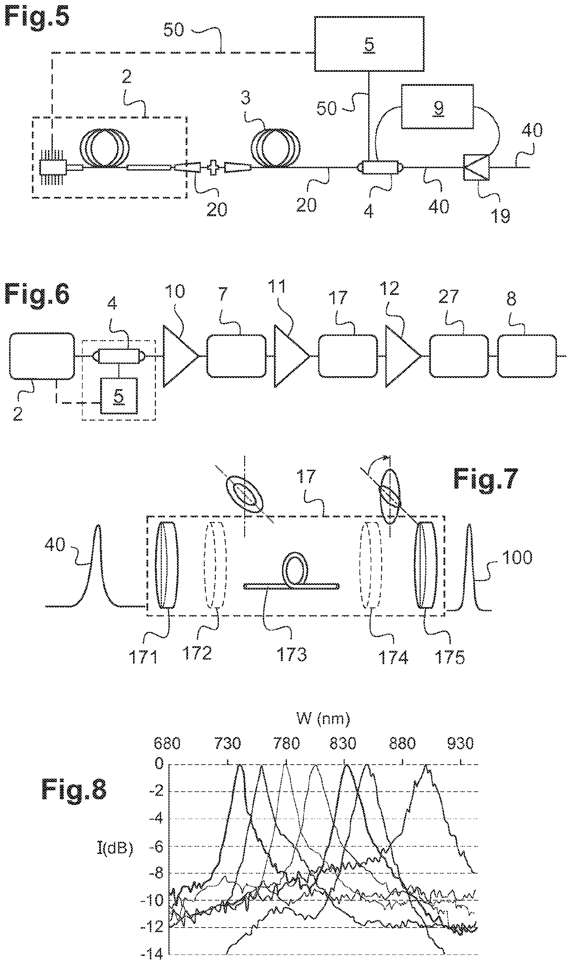

Selon un aspect particulier, décrit en lien avec la figure 5, le système comporte en outre une boucle de rétroaction pour contrôler le rapport signal à bruit du rayonnement lumineux modulé. Un coupleur optique 19 est disposé en sortie du modulateur électro-optique et configuré pour prélever une petite portion (par exemple 1%) du rayonnement lumineux modulé 40. Un système de détection 9 est configuré pour mesurer une intensité de la portion du rayonnement lumineux modulé dans une bande passante allant jusque plusieurs dizaines de gigahertz. Une carte électronique hyperfréquence permet d'analyser cette mesure et de générer un signal de biais en fonction d'une mesure de contraste, de rapport signal à bruit ou de niveau d'extinction du signal lumineux modulé 40. Un signal électronique analogique de rétroaction permet ainsi d'appliquer une tension de biais sur le modulateur électro-optique 4 en fonction du signal de biais. Ce dispositif de rétroaction permet d'adapter la tension appliquée sur le modulateur électro-optique en fonction par exemple de l'extinction du faisceau lumineux modulé. Ce dispositif de rétroaction permet de maintenir un excellent rapport sur bruit et un contraste élevé du modulateur électro-optique 4 sur toute la gamme de durée d'impulsion et de cadence.

Dans un mode de réalisation particulier décrit en lien avec la figure 6, le système de génération d'impulsions lumineuses brèves ou ultra-brèves comporte en outre un dispositif d'amplification optique disposé en sortie du modulateur électro-optique 4. Le dispositif d'amplification optique comporte un amplificateur optique ou plusieurs amplificateurs optiques disposés en série pour recevoir le rayonnement lumineux modulé 40 et pour générer un rayonnement lumineux impulsionnel amplifié. Par exemple, le dispositif d'amplification optique comporte un premier préamplificateur optique 10, un autre préamplificateur optique 11 et un amplificateur optique de puissance 12. On utilise par exemple des amplificateurs optiques à base de fibres optiques dopées (Yb, Er, Th et/ou Nd) et/ou des amplificateurs à cristaux et/ou en verre dopé (par exemple Yb :YLF, Yb :YAG, Yb :CALGO, Yb :CaF2, Yb :LUAG, Nd :YAG, ou Er :YAG ou Ho :YAG). Entre les différents étages d'amplification, on dispose avantageusement des filtres optiques de longueur d'onde fixe ou accordable, synchronisés entre eux, permettant de supprimer l'émission spontanée amplifiée générée dans les amplificateurs optiques.

La technique de compression temporelle permet la réalisation d'une source lumineuse générant des impulsions lumineuses de durée inférieure à 10 ps, par exemple picoseconde ou femtoseconde.

De façon avantageuse, on utilise un dispositif d'élargissement spectral avant l'étage d'amplification de puissance, afin d'élargir le spectre de l'impulsion lumineuse préalablement à son amplification. Ainsi, le dispositif d'amplification optique génère une impulsion lumineuse amplifiée ayant un spectre chirpé temporellement qui peut ensuite être recomprimée temporellement au moyen d'un compresseur à dispersion. De manière connue, il est alors possible, après amplification, de recomprimer temporellement l'impulsion lumineuse amplifiée pour atteindre une durée picoseconde ou femtoseconde. Le compresseur 8 peut être à base de réseau(x) de diffraction, de prisme(s), de miroir(s) dispersif(s) et/ou de fibre(s) optique(s) présentant une dispersion particulière.

Un premier exemple de réalisation repose sur l'utilisation d'un module dispersif 7. A titre d'exemple non limitatif, le module dispersif 7 comprend une grande longueur (entre 30m et 300 m) de fibre optique passive à maintien de polarisation PM ou de fibre à cristaux photoniques (PCF) ou à saut d'indice. Par des effets non-linéaires comme l'automodulation de phase (SPM), une telle fibre optique produit un l'élargissement spectral d'une impulsion lumineuse. En effet, les variations de phase accumulées par SPM au cours de la propagation de l'impulsion lumineuse dans la fibre optique induisent des changements dans l'enveloppe temporelle de l'impulsion sans modification de son amplitude. De manière connue, dans le domaine fréquentiel, ces variations de phase se traduisent par un étalement du spectre de l'impulsion, puisque celui-ci est la dérivée du déphasage non-linéaire. L'automodulation de phase a pour effet de décaler les composantes de basses fréquences vers le front de l'impulsion et les composantes de hautes fréquences vers la queue de l'impulsion, ce qui est l'inverse des effets de dispersion en régime anormal produit par les fibres silice pour des longueurs d'onde de l'ordre de 1 µm.

Un autre exemple de réalisation repose sur l'utilisation d'un module 17 de rotation non-linéaire de polarisation (RNLP) disposé entre le deuxième étage de préamplification 11 et l'amplificateur de puissance 12. La figure 7 illustre la structure et le fonctionnement d'un module RNLP 17. Le module RNLP 17 comporte ici un élément polarisant 171, une fibre optique 173 passive (non PM) et un contrôleur de polarisation 172. Une impulsion lumineuse 40 voit sa polarisation évoluer non linéairement lors de sa propagation dans la fibre optique 173 par effet Kerr. Après un polariseur 171 (ou isolateur), une impulsion incidente 40 se retrouve avec toutes ses composantes polarisées linéairement. Le contrôleur de polarisation 172 permet de changer la polarisation linéaire en polarisation elliptique. L'impulsion lumineuse polarisée elliptiquement subit une évolution non-linéaire de son état de polarisation lors de sa propagation dans la fibre optique 173. Ceci est dû aux effets combinés de l'automodulation de phase et de la modulation de phase croisée induite sur les deux composantes de la polarisation par effet Kerr. Les différentes composantes temporelles de l'impulsion lumineuse ne perçoivent pas le même indice de réfraction, car celui-ci dépend de l'intensité crête, ce qui change l'état de polarisation et induit un déphasage entre les différentes composantes de l'impulsion lumineuse. En conséquence, la partie la plus intense de l'impulsion lumineuse, représentée en trait épais sur la figure 7, subit une rotation de polarisation d'un angle qui dépend du maximum de l'intensité du champ électrique, changeant ainsi la position de l'axe de l'ellipse. Au contraire, la partie la moins intense de l'impulsion lumineuse, représentée en trait fin sur la figure 7, ne subit pas de rotation de polarisation. L'angle de rotation de la polarisation est donc proportionnel à l'intensité. En sortie de la fibre optique 173, un autre contrôleur de polarisation 174 est orienté de manière à compenser la biréfringence linéaire de la fibre pour transformer un état de polarisation elliptique en un état de polarisation linéaire. Enfin, un autre polariseur 175 est disposé pour analyser la polarisation en laissant passer la partie la plus intense de l'impulsion lumineuse dont la polarisation a tourné. Cette partie intense subit alors moins de pertes que la partie moins intense de l'impulsion lumineuse. L'impulsion lumineuse 100 obtenue a ainsi une durée réduite. Dans cet exemple de réalisation, il n'est pas nécessaire d'utiliser un compresseur. Cet exemple de réalisation présente des avantages de facilité de réalisation et de coût limité.

Encore un autre exemple de réalisation repose sur l'utilisation d'un module 27 de conversion de fréquence par mélange à quatre ondes dégénéré (FWM) après le dernier étage d'amplification. Un tel module 27 permet de générer une nouvelle longueur d'onde, de préférence dans le domaine visible, avec un élargissement spectral dû à la modulation de phase croisée. La bande spectrale, de plusieurs nanomètres, obtenue par FWM et par élargissement spectral, permet de recomprimer une impulsion lumineuse ayant une durée de quelques picosecondes à une durée de l'ordre de la centaine de femtoseconde. En effet, le FWM dégénéré apparaît lorsque deux photons de pompe identiques sont annihilés pour produire deux photons avec des longueurs d'onde différentes et la même énergie totale. Lorsque plusieurs ondes de longueurs d'onde différentes se propagent dans une fibre optique, leurs battements créent, via l'effet Kerr optique et les effets de diffraction, un réseau d'indice. Cette modulation périodique de l'indice induit un processus physique de transfert d'énergie entre les fréquences qui, par diffraction temporelle, est susceptible de générer de nouvelles fréquences. Celles-ci en raison de la condition de conservation de l'énergie, sont des combinaisons particulières des fréquences initiales. La propagation simultanée de ces différentes ondes dans une même fibre optique entraîne, par modulation de phase croisée (XPM) un élargissement spectral de l'impulsion. Cet effet est une conséquence directe de l'effet Kerr optique qui se manifeste par la modification de l'indice de réfraction d'un milieu sous l'effet d'un champ électrique intense. En effet lorsque deux ondes se propagent simultanément dans une fibre optique, l'une subit les effets de la première sur le milieu, et réciproquement. Ainsi, une impulsion va subir un déphasage non-linéaire induit par une deuxième impulsion. Ces impulsions lumineuses peuvent ainsi être comprimées à des durées inférieures à 1 ps. Dans ce cas, l'impulsion lumineuse comprimée a une durée inférieure à l'impulsion électrique appliquée sur le modulateur électro-optique 4.

La figure 8 illustre un exemple de d'utilisation du système de génération d'impulsions lumineuses brèves ou ultrabrèves comprenant une source lumineuse 2 infrarouge émettant autour de 1µm et un dispositif FWM configuré de manière à générer des impulsions lumineuses ayant un spectre d'émission accordable en longueur d'onde. On fabrique ainsi système de génération d'impulsions lumineuses brèves ou ultrabrèves continument accordable en longueur d'onde de 750 nm à environ 900 nm.

Le système de génération d'impulsions lumineuses brèves ou ultra-brèves tel que décrit dans l'un des modes de réalisation détaillé ci-dessus ouvre de nouvelles perspectives dans le domaine des procédés lasers. Par exemple, dans un système de déplacement d'un faisceau lumineux impulsionnel basé sur les mouvements d'une tête galvanométrique ou d'une lentille F-Thêta, les accélérations et décélérations des mouvements nuisent à l'uniformité du dépôt d'énergie. Le système objet de la présente divulgation permet de synchroniser en temps réel la cadence des impulsions lumineuses avec un système de déplacement du faisceau lumineux et ainsi de réaliser un traitement laser avec un dépôt constant d'énergie en tenant compte des accélérations du système de déviation du faisceau. La facilité d'accordabilité de durée et/ou de cadence des impulsions lumineuses permet ainsi d'améliorer la précision et la régularité d'un traitement laser. De plus, ce système permet d'adapter un procédé laser dans une gamme de paramètres multiples et sur une dynamique très étendue puisqu'il est à la fois possible d'ajuster la longueur d'onde, la cadence et la durée des impulsions au cours de l'opération laser afin d'adapter les interactions du laser avec le matériau. Il est ainsi possible de réaliser des traitements continus d'éléments de composition inhomogène tout en conservant des paramètres lasers optimums, avec une seule et unique source lumineuse.

Dans un mode de réalisation particulier, le système de génération d'impulsions lumineuses brèves ou ultra-brèves trouve aussi des applications à un système et procédé d'imagerie plein champ basé sur une excitation de fluorescence multiphotonique adaptée aux études biologiques sur cellules et tissus vivants. L'imagerie multiphotonique est basée sur un phénomène non-linéaire, dans lequel le signal varie de manière inversement proportionnelle au carré de la durée d'impulsion. D'autre part, le système de génération d'impulsions lumineuses permet d'ajuster la cadence d'émission des impulsions lumineuses sur une gamme de fréquence qui s'étend de quelques kHz à plusieurs GHz. Cette gamme de cadence est inaccessible par les technologies actuelles et permet d'ajuster finement le rapport signal sur bruit en fonction de la cible imagée tout en restant dans une gamme d'impulsions lumineuses non-destructives.

Selon un mode de réalisation particulier et avantageux, le système de génération d'impulsions lumineuses brèves ou ultra-brèves met en œuvre la technologie de fibre optique dopée ytterbium. La fibre optique dopée ytterbium est particulièrement adaptée à l'amplification jusqu'à des puissances moyennes de plus de 50 W, à comparer avec les quelques W fournis par un oscillateur optique conventionnel. Il est alors possible d'illuminer une zone de plusieurs cm² et de former une image de plein champ. A titre de comparaison, les technologies actuelles d'imagerie laser sont généralement basées sur une focalisation d'un faisceau laser en un point de 50 µm², d'un balayage de la surface à imager et d'une reconstruction point par point de l'image, ce qui rend ces techniques extrêmement longues. Au contraire, l'imagerie en combinaison avec le système de génération d'impulsions lumineuses brèves ou ultra-brèves proposé ici constitue donc une véritable rupture technologique puisque l'image est obtenue en une seule fois. Une camera ultrarapide permet de plus d'accéder à la dynamique temporelle, par exemple pour suivre l'évolution de cellules biologiques, précédemment inaccessible par reconstruction d'image point-par-point.

## Revendications

1. Système (1) de génération d'impulsions lumineuses brèves ou ultra-brèves comprenant :
- une source lumineuse (2) adaptée pour émettre un rayonnement lumineux (20) ;
- un générateur électrique (5) comprenant une carte électronique hyperfréquence, la carte électronique hyperfréquence comprenant deux portes logiques inversées l'une par rapport à l'autre, le générateur électrique étant configuré pour opérer à une fréquence accordable dans une bande passante s'étendant jusqu'à au moins un gigahertz et pour émettre un signal électrique analogique de modulation (50) comprenant au moins une impulsion électrique de durée comprise entre une picoseconde et quelques nanosecondes;
- des moyens de modulation électriques ou électro-optiques ayant une bande passante électrique adaptée pour recevoir le signal électrique analogique de modulation (50), les moyens de modulation électriques ou électro-optiques étant configurés pour moduler en amplitude le rayonnement lumineux (20) en fonction du signal électrique analogique de modulation (50) et pour générer un rayonnement lumineux modulé (40) comprenant au moins une impulsion lumineuse de durée comprise entre 10 ps et quelques nanosecondes,
**caractérisé en ce que** :
les deux portes logiques sont reliées par une ligne à retard électronique variable et le signal électrique analogique de modulation (50) comprend au moins une impulsion électrique de durée déterminée par la ligne à retard électronique variable.

2. Système selon la revendication 1 dans lequel le générateur électrique (5) est configuré pour émettre le signal électrique analogique de modulation (50) comprenant ladite au moins une impulsion électrique de durée comprise entre 10 ps et quelques nanosecondes et dans lequel la source lumineuse (2) comprend une diode laser ayant des électrodes, lesdits moyens de modulation étant configurées pour appliquer directement ledit signal électrique analogique de modulation (50) sur les électrodes de la diode laser.

3. Système selon la revendication 2 dans lequel le générateur électrique (5) est configuré pour opérer à une fréquence accordable dans une bande passante s'étendant jusqu'au moins dix gigahertz et pour émettre le signal électrique analogique de modulation (50) comprenant ladite au moins une impulsion électrique de durée comprise entre 10 ps et 50 ps et dans lequel la diode laser est commutée en gain, de manière à ce que la diode laser génère le rayonnement lumineux modulé (40) comprenant au moins une impulsion lumineuse de durée comprise entre 10 ps et 50 ps à une cadence s'étendant jusqu'au moins dix gigahertz.

4. Système selon la revendication 1 dans lequel :
- la source lumineuse (2) est adaptée pour émettre un rayonnement lumineux (20) continu temporellement,
- le générateur électrique (5) est configuré pour opérer à une fréquence accordable dans une bande passante comprise entre un gigahertz et une centaine de gigahertz et pour émettre le signal électrique analogique de modulation (50) comprenant ladite au moins une impulsion électrique de durée comprise entre dix picosecondes et une centaine de picosecondes; et
- le système comprenant en outre un modulateur électro-optique (4) ayant des électrodes et une bande passante électrique adaptées pour recevoir le signal électrique analogique de modulation (50), le modulateur électro-optique étant configuré pour moduler optiquement en amplitude le rayonnement lumineux (20) continu en fonction du signal électrique analogique de modulation (50) et pour générer le rayonnement lumineux modulé (40) comprenant ladite au moins une impulsion lumineuse de durée comprise entre dix picosecondes et une centaine de picosecondes.

5. Système selon la revendication 4 dans lequel le générateur électrique est configuré pour émettre ledit signal électrique analogique de modulation (50) comprenant un train d'impulsions électriques de durée comprise entre 10 ps et 10 ns à une cadence accordable dans une gamme de fréquence comprise entre 10 kHz et 20 Ghz et dans lequel le modulateur électro-optique est configuré pour moduler le rayonnement lumineux continu en fonction du signal électrique analogique de modulation (50) et pour générer un rayonnement lumineux modulé (40) comprenant un train d'impulsions lumineuses de durée comprise entre 10 ps et 10 ns, lesdites impulsions lumineuses ayant ladite cadence accordable.

6. Système selon l'une des revendications 1 à 5 comprenant en outre un compresseur (8) configuré pour recevoir ladite au moins une impulsion lumineuse de durée comprise entre dix picosecondes et une centaine de picosecondes et pour générer une impulsion lumineuse comprimée (100) de durée inférieure ou égale à une picoseconde.

7. Système selon la revendication 6 comprenant en outre au moins un dispositif optique (7, 17, 27) disposé entre la source lumineuse (2) et le compresseur (8), le dispositif optique (7, 17, 27) étant choisi parmi un dispositif optique spectralement dispersif (7), un dispositif optique polarisant (17) ou un dispositif optique non linéaire (27).

8. Système selon la revendication 1 à 7 dans lequel la source lumineuse (2) est configurée pour émettre un rayonnement lumineux continu monochromatique ou polychromatique.

9. Système selon la revendication 1 à 8 comprenant un dispositif d'accord d'une longueur d'onde du rayonnement lumineux (20).

10. Système selon l'une des revendications 1 à 9 dans lequel la source lumineuse comprend une diode laser ou une source laser à fibre optique dopée terre rare, choisie parmi une source laser à fibre optique dopée erbium, ytterbium, thulium ou néodyme.

11. Système selon l'une des revendications 1 à 10 comprenant un dispositif d'amplification optique (10, 11, 12) configuré pour recevoir le rayonnement lumineux modulé (40) et pour générer un rayonnement lumineux impulsionnel amplifié.

12. Système selon l'une des revendications 1 à 11 comprenant un coupleur optique disposé en sortie des moyens de modulation électriques ou électro-optiques et configuré pour prélever une portion du rayonnement lumineux modulé, un système de détection configuré pour mesurer une intensité de la portion du rayonnement lumineux modulé dans une bande passante s'étendant jusqu'à au moins un gigahertz et une boucle de rétroaction disposée pour appliquer un signal de biais sur le signal de modulation en fonction de l'intensité mesurée.

13. Système selon l'une des revendications 1 à 12 comprenant un système optique agrandisseur de faisceau disposé pour recevoir le rayonnement lumineux modulé et pour diriger un faisceau lumineux modulé agrandi sur une zone à analyser et un système de détection d'image configuré pour former une image de ladite zone.

14. Procédé de génération d'impulsions lumineuses brèves ou ultra-brèves comprenant les étapes suivantes:
- émission d'un rayonnement lumineux (20) ;
- génération, au moyen d'une carte électronique hyperfréquence, la carte électronique hyperfréquence comprenant deux portes logiques inversées l'une par rapport à l'autre, les deux portes logiques étant reliées par une ligne à retard électronique variable, d'un signal électrique analogique de modulation (50) ayant une fréquence dans une bande passante hyperfréquence comprise entre 10 kHz et 20 Ghz, le signal électrique analogique de modulation comprenant au moins une impulsion électrique de durée déterminée par la ligne à retard électronique variable, la durée de l'impulsion électrique étant comprise entre une picoseconde et quelques nanosecondes ;
- application du signal électrique analogique de modulation aux électrodes d'un modulateur électro-optique ou d'une diode laser, le modulateur électro-optique ou la diode laser étant configurés pour moduler optiquement en amplitude le rayonnement lumineux (20) en fonction du signal électrique analogique de modulation (50) et pour générer un rayonnement lumineux modulé (40) comprenant au moins une impulsion lumineuse de durée comprise entre 10 ps et 100 ps.

15. Procédé selon la revendication 14 dans lequel la diode laser est commutée en gain, de manière à ce que la diode laser génère le rayonnement lumineux modulé comprenant au moins une impulsion lumineuse de durée comprise entre 10 ps et 50 ps à une cadence s'étendant jusqu'au moins dix gigahertz.

## Patentansprüche

1. System (1) zum Erzeugen von kurzen oder ultrakurzen Lichtimpulsen mit
- einer Lichtquelle (2), die zum Aussenden einer Lichtstrahlung ausgelegt ist,
- einem elektrischen Generator (5), der eine elektronische Hochfrequenzkarte aufweist, wobei die elektronische Hochfrequenzkarte zwei zueinander inverse logische Gatter aufweist, wobei der elektrische Generator dazu ausgelegt ist, bei einer abstimmbaren Frequenz in einer bis zu wenigstens einem Gigahertz reichenden Bandbreite zu arbeiten und ein analoges elektrisches Modulationssignal (50) auszusenden, das wenigstens einen elektrischen Impuls mit einer Dauer zwischen einer Picosekunde und einigen Nanosekunden aufweist,
- elektrischen oder elektrooptischen Modulationsmitteln mit einer elektrischen Bandbreite, die dazu ausgelegt ist, das analoge elektrische Modulationssignal (50) zu empfangen, wobei die elektrischen oder elektrooptischen Modulationsmittel dazu ausgelegt sind, die Lichtstrahlung (20) in Abhängigkeit vom analogen elektrischen Modulationssignal (50) hinsichtlich der Amplitude zu modulieren und eine modulierte Lichtstrahlung (40) zu erzeugen, die wenigstens einen Lichtimpuls mit einer Dauer zwischen 10 ps und einigen Nanosekunden aufweist,
**dadurch gekennzeichnet, daß**
die beiden logischen Gatter durch eine variable elektronische Verzögerungsleitung verbunden sind und das analoge elektrische Modulationssignal (50) wenigstens einen elektrischen Impuls mit durch die variable elektronische Verzögerungsleitung bestimmter Dauer aufweist.

2. System gemäß Anspruch 1, bei dem der elektrische Generator (5) dazu ausgelegt ist, das den wenigstens einen Lichtimpuls mit einer Dauer zwischen 10 ps und einigen Nanosekunden aufweisende analoge elektrische Modulationssignal (50) auszusenden, und bei dem die Lichtquelle (2) eine Laserdiode mit Elektroden aufweist, wobei die Modulationsmittel dazu ausgelegt sind, das analoge elektrische Modulationssignal (50) direkt an die Elektroden der Laserdiode anzulegen.

3. System gemäß Anspruch 2, bei dem der elektrische Generator (5) dazu ausgelegt ist, bei einer in einer bis zu wenigstens zehn Gigahertz reichenden Bandbreite abstimmbaren Frequenz zu arbeiten und das den wenigstens einen Lichtimpuls mit einer Dauer zwischen 10 ps und einigen Nanosekunden aufweisende analoge elektrische Modulationssignal (50) auszusenden, und bei dem die Laserdiode verstärkungsmäßig so geschaltet wird, daß die Laserdiode die modulierte Lichtstrahlung (40), die wenigstens einen Lichtimpuls mit einer Dauer zwischen 10 ps und einigen Nanosekunden aufweist, mit einer sich bis wenigstens zehn Gigahertz erstreckenden Kadenz erzeugt.

4. System gemäß Anspruch 1, bei dem
- die Lichtquelle (2) dazu ausgelegt ist, eine zeitlich kontinuierliche Lichtstrahlung (20) auszusenden,
- der elektrische Generator (5) dazu ausgelegt ist, bei einer abstimmbaren Frequenz in einer Bandbreite zwischen einem Gigahertz und etwa einhundert Gigahertz zu arbeiten und das analoge elektrische Modulationssignal (50), das wenigstens einen elektrischen Impuls mit einer Dauer zwischen zehn Picosekunden und einigen Nanosekunden aufweist, auszusenden,
- wobei das System außerdem einen elektrooptischen Modulator (4) mit Elektroden und einer elektrischen Bandbreite, die dazu ausgelegt sind, das analoge elektrische Modulationssignal (50) zu empfangen, aufweist, wobei der elektrooptische Modulator dazu ausgelegt ist, die kontinuierliche Lichtstrahlung (20) in Abhängigkeit vom analogen elektrische Modulationssignal (50) hinsichtlich der Amplitude optisch zu modulieren und um die modulierte Lichtstrahlung (40) zu erzeugen, die wenigstens einen Lichtimpuls mit einer Dauer zwischen zehn Picosekunden und etwa hundert Picosekunden aufweist.

5. System gemäß Anspruch 4, bei dem der elektrische Generator dazu ausgelegt ist, das analoge elektrische Modulationssignal (50) auszusenden, das eine Folge elektrischer Impulse mit einer Dauer zwischen 10 ps und 10 ns mit einer in einem Frequenzbereich zwischen 10 kHz und 20 GHz abstimmbaren Kadenz aufweist, und bei dem der elektrooptische Modulator dazu ausgelegt ist, die kontinuierliche Lichtstrahlung in Abhängigkeit vom analogen elektrischen Modulationssignal (50) zu modulieren, und eine modulierte Lichtstrahlung (40) zu erzeugen, die eine Folge elektrischer Impulse mit einer Dauer zwischen 10 ps und 10 ns aufweist, wobei die Lichtimpulse die abstimmbare Kadenz aufweisen.

6. System gemäß einem der Ansprüche 1 bis 5, das außerdem einen Kompressor (8) aufweist, der dazu ausgelegt ist, den wenigstens einen Lichtimpuls mit einer Dauer zwischen zehn Picosekunden und etwa hundert Picosekunden zu empfangen und einen komprimierten Lichtimpuls (40) mit einer Dauer von weniger als oder gleich einer Picosekunde zu empfangen.

7. System gemäß Anspruch 6, das außerdem wenigstens eine optische Vorrichtung (7, 17, 27) aufweist, die zwischen der Lichtquelle (2) und dem Kompressor (8) angeordnet ist, wobei die optische Vorrichtung (7, 17, 27) aus einer spektral dispersiven optischen Vorrichtung (7), einer optisch polarisierenden Vorrichtung (17) oder einer nichtlinearen optischen Vorrichtung (27) ausgewählt ist.

8. System gemäß einem der Ansprüche 1 bis 7, bei dem die Lichtquelle (2) dazu ausgelegt ist, eine monochrome oder polychrome kontinuierliche Lichtstrahlung auszusenden.

9. System gemäß einem der Ansprüche 1 bis 8, das eine Vorrichtung zum Abstimmen einer Wellenlänge der Lichtstrahlung (20) aufweist.

10. System gemäß einem der Ansprüche 1 bis 9, bei dem die Lichtquelle eine Laserdiode oder eine Laserquelle mit mit Seltenen Erden dotierten optischen Fasern, die aus einer mit Erbium, mit Ytterbium, mit Thulium oder Neodym dotierten Laserquelle ausgewählt ist, aufweist.

11. System gemäß einem der Ansprüche 1 bis 10, das eine optische Verstärkervorrichtung (10, 11, 12) aufweist, die dazu ausgelegt ist, die modulierte Lichtstrahlung (40) zu empfangen und eine verstärkte impulsartige Lichtstrahlung zu erzeugen.

12. System gemäß einem der Ansprüche 1 bis 11, das einen optischen Koppler, der am Ausgang der elektrischen oder elektrooptischen Modulationsmittel angeordnet ist und dazu ausgelegt ist, einen Teil der modulierten Lichtstrahlung zu entnehmen, ein Erfassungssystem, das dazu ausgelegt ist, eine Stärke des Teils der sich in einer bis zu wenigstens einem Gigahertz erstreckenden Bandbreite modulierten Lichtstrahlung zu messen und eine Rückkopplungsschleife, die so angeordnet ist, daß sie auf das Modulationssignal ein Vorspannungssignal in Abhängigkeit von der gemessenen Stärke anlegt, aufweist.

13. System gemäß einem der Ansprüche 1 bis 12, das ein optisches System zum Vergrößern des Strahls, das zum Empfangen der modulierten Lichtstrahlung und zum Richten einer vergrößerten modulierten Lichtstrahlung auf eine zu analysierende Zone angeordnet ist, und ein System zur Bilderfassung, das zum Bilden eines Bilds der Zone ausgelegt ist, aufweist.

14. Verfahren zum Erzeugen von kurzen oder ultrakurzen Lichtimpulsen, das die folgenden Schritte aufweist:
- Aussenden einer Lichtstrahlung (20),
- Erzeugen eines analogen elektrischen Modulationssignals (50) mittels einer elektronischen Hochfrequenzkarte, die zwei zueinander inverse logische Gatter aufweist, wobei die beiden logischen Gatter durch eine variable elektronische Verzögerungsleitung verbunden sind, wobei das Signal eine Frequenz in einer Hochfrequenzbandbreite zwischen 10 kHz und 20 GHz aufweist, wobei das analoge elektrische Modulationssignal wenigstens einen Impuls mit durch die variable elektronische Verzögerungsleitung bestimmter Dauer aufweist, wobei die Dauer des elektrischen Impulses zwischen einer Picosekunde und einigen Nanosekunden liegt,
- Anlegen des analogen elektrischen Modulationssignals an die Elektroden eines elektrooptischen Modulators oder einer Laserdiode, wobei der elektrooptische Modulator oder die Laserdiode dazu ausgelegt sind, die Lichtstrahlung (20) hinsichtlich der Amplitude in Abhängigkeit vom analogen elektrischen Modulationssignal optisch zu modulieren und eine modulierte Lichtstrahlung (40) zu erzeugen, die wenigstens einen Lichtimpuls mit einer Dauer zwischen 10 ps und 100 ps aufweist.

15. Verfahren gemäß Anspruch 14, bei dem die Laserdiode hinsichtlich der Verstärkung so geschaltet wird, daß die Laserdiode die modulierte Lichtstrahlung, die wenigstens einen Lichtimpuls mit einer Dauer zwischen 10 ps und 50 ps aufweist, mit einer sich bis wenigstens zehn Gigahertz erstreckenden Kadenz erzeugt.

## Claims

1. A system (1) for generating short or ultra-short light pulses comprising:
- a light source (2) adapted to emit a light radiation (20);
- a power generator (5) configured to operate at a frequency tunable over a bandwidth extending up to at least one gigahertz and to emit an analog electrical modulation signal (50) comprising at least one electrical pulse of duration comprised between one picosecond and a few nanoseconds;
- electrical or electro-optical modulation means having an electrical bandwidth adapted to receive the analog electrical modulation signal (50), the electrical or electro-optical modulation means being configured to modulate the light radiation (20) in amplitude as a function of the analog electrical modulation signal (50) and to generate a modulated light radiation (40) comprising at least one light pulse of duration comprised between 10 ps and a few nanoseconds.

2. The system according to claim 1, wherein the power generator (5) is configured to emit the analog electrical modulation signal (50) comprising said at least one electrical pulse of duration comprised between 10 ps and a few nanoseconds and wherein the light source (2) comprises a laser diode having electrodes, said modulation means being configured to apply said analog electrical modulation signal (50) to the electrodes of the laser diode.

3. The system according to claim 2, wherein the power generator (5) is configured to operate at a frequency tunable over a bandwidth extending up to at least ten gigahertz and to emit the analog electrical modulation signal (50) comprising said at least one electrical pulse of duration comprised between 10 ps and 50ps and wherein the laser diode is gain switched, so that the laser diode generates the modulated light radiation (40) comprising at least one light pulse of duration comprised between 10 ps and 50 ps at a rate extending up to at least ten gigahertz.

4. The system according to claim 1, wherein:
- the light source (2) is adapted to emit a temporally continuous light radiation (20),
- the power generator (5) is configured to operate at a frequency tunable over a bandwidth comprised between one gigahertz and one hundred of gigahertz and to emit the analog electrical modulation signal (50) comprising said at least one electrical pulse of duration comprised between ten picoseconds and one hundred of picoseconds; and
- the system further comprises an electro-optical modulator (4) having electrodes and an electrical bandwidth adapted to receive the analog electrical modulation signal (50), the electro-optical modulator being configured to optically modulate the continuous light radiation (20) in amplitude as a function of the analog electrical modulation signal (50) and to generate a modulated light radiation (40) comprising said at least one light pulse of duration comprised between ten picoseconds and about one hundred picoseconds.

5. The system according to claim 4, wherein the power generator is configured to emit said analog electrical modulation signal (50) comprising an electrical pulse train of duration comprised between 10 ps and 10 ns at a rate tunable over a frequency range comprised between 10 kHz and 20 GHz and wherein the electro-optical modulator is configured to modulate the continuous light radiation as a function of the analog electrical modulation signal (50) and to generate a modulated light radiation (40) comprising a train of light pulses of duration comprised between 10 ps and 10 ns, said light pulses having said tunable rate.

6. The system according to one of claims 1 to 5, further comprising a compressor (8) configured to receive said at least one light pulse of duration comprised between ten picoseconds and one hundred of picoseconds and to generate a compressed light pulse (100) of duration lower than or equal to one picosecond.

7. The system according to claim 6, further comprising at least one optical device (7, 17, 27) arranged between the light source (2) and the compressor (8), the optical device (7, 17, 27) being chosen among a spectrally dispersive optical device (7), a polarizing optical device (17) or a nonlinear optical device (27).

8. The system according to claim 1 to 7, wherein the light source (2) is configured to emit a monochromatic or polychromatic continuous light radiation.

9. The system according to claim 1 to 8, comprising a device for tuning a wavelength of the light radiation (20).

10. The system according to one of claims 1 to 9, wherein the light source comprises a rare-earth-doped optical fibre laser diode or laser source, chosen among an erbium, ytterbium, thulium or neodymium-doped optical fibre laser source.

11. The system according to one of claims 1 to 10, comprising an optical amplification device (10, 11, 12) configured to receive the modulated light radiation (40) and to generate an amplified pulse light radiation.

12. The system according to one of claims 1 to 11, comprising an optical coupler arranged at the exit of the electrical or electro-optical modulation means and configured to pick-up a portion of the modulated light radiation, a detection system configured to measure an intensity of the portion of the modulated light radiation in a bandwidth extending up to at least one gigahertz and a feedback loop arranged to apply a bias signal to the modulation signal as a function of the intensity measured.

13. The system according to one of claims 1 to 12, comprising a beam-expander optical system arranged to receive the modulated light radiation and to direct an expanded modulated light beam to a zone to be analysed and an image detection system configured to form an image of said zone.

14. A method for generating short or ultra-short light pulses comprising the following steps:
- emitting a light radiation (20),
- generating an analog electrical modulation signal (50) having a frequency in a microwave bandwidth comprised between 10 kHz and 20 GHz, the analog electrical modulation signal comprising at least one electrical pulse of duration comprised between one picosecond and a few nanoseconds;
- applying the analog electrical modulation signal to the electrodes of an electro-optical modulator or of a laser diode, the electro-optical modulator or the laser diode being configured to optically modulate the light radiation (20) in amplitude as a function of the analog electrical modulation signal (50) and to generate a modulated light radiation (40) comprising at least one light pulse of duration comprised between 10 ps and 100 ps.

15. The method according to claim 14, wherein the laser diode is gain switched, so that the laser diode generates the modulated light radiation comprising at least one light pulse of duration comprised between 10 ps and 50 ps at a rate extending up to at least ten gigahertz.
